# EUROPEAN PATENT APPLICATION

(11) **EP 3 159 937 A1**
(43) Date of publication of application: **26.04.2017**
(21) Application number: 16151192.8
(22) Date of filing: 14.01.2016
(51) Int. Cl.: H01L 31/048, H01L 31/049, H02S 40/34, H02S 40/36, H02S 20/20, H02S 30/10

(54) **FLEXIBLE SOLAR PANEL MODULE**

(30) Priority: 22.10.2015 TW 104134754
(71) Applicant: Eterbright Solar Corporation, Toufen City, Miaoli County (TW)
(72) Inventor: HUANG, TING-HUI, 35154 Miaoli County (TW)
(74) Representative: Straus, Alexander

(57) **Abstract**

A flexible solar panel module (1000) has a plurality of solar panels (100, 100'), a plurality of cover panels (130), a plurality of flexible back sheets (140) and a flexible polymer thin film (160). The plurality of cover panels (130) correspond to the plurality of solar panels (100, 100') and covers front sides of the plurality of solar panels (100, 100') respectively. The plurality of flexible back sheets (140) correspond to the plurality of solar panels (100, 100') and disposed at back sides of the plurality of solar panels (100, 100') respectively. The flexible polymer thin film (160) has a plurality of openings (161, 161') therein correspond to the plurality of solar panels (100, 100') and a size of each of the plurality of openings (161, 161') is smaller than a size of each of the plurality of cover panels (130) and bigger than a size of each of the plurality of solar panels (100, 100'). The flexible polymer thin film (160) is disposed between the plurality of flexible back sheets (140) and the plurality of cover panels (130). The plurality of openings (161, 161') are so formed in the flexible polymer thin film (160) that the plurality of solar panels (100, 100') sandwiched between the plurality of flexible back sheets (140) and the plurality of cover panels (130) are embedded in the plurality of openings (161, 161') respectively.

## Description

### FIELD OF THE DISCLOSURE

The present invention relates to flexible solar panel module.

### BACKGROUND OF THE INVENTION

In order to achieve higher power output, traditional solar panel modules usually integrate multiple solar panels. By doing so, traditional solar panel modules have large sizes and require large spaces for installation. Newer solar panel modules may have better flexibility to fit topography and better portability, but they require higher manufacturing cost and have lower power output.

Therefore, the industry needs an improved water-resistant flexible solar panel module which can be manufactured with less cost and is capable of outputting higher power.

### SUMMARY OF THE INVENTION

One purpose of the present invention is to provide a flexible solar panel module. Flexible solar panel module has a plurality of solar panels, a plurality of non-flexible cover panels, a plurality of flexible back sheets and a flexible polymer thin film. The plurality of non-flexible cover panels correspond to the plurality of solar panels and covers front sides of the plurality of solar panels respectively. The plurality of back sheets correspond to the plurality of solar panels and disposed at back sides of the plurality of solar panels respectively. The flexible polymer thin film has a plurality of openings therein correspond to the plurality of solar panels and a size of each of the plurality of openings is smaller than a size of each of the plurality of cover panels and bigger than a size of each of the plurality of solar panels. The flexible polymer thin film is disposed between the plurality of back sheets and the plurality of cover panels. The plurality of openings are so formed in the flexible polymer thin film that the plurality of solar panels sandwiched between the plurality of back sheets and the plurality of cover panels are embedded in the plurality of openings respectively.

According to one embodiment of the present invention, the flexible solar panel module further comprises a junction box disposed on the front sides of the plurality of solar panels.

According to one embodiment of the present invention, each of the plurality of solar panels comprises a photoelectric conversion layer, a positive ribbon and a negative ribbon, wherein the positive ribbons and the negative ribbons of the plurality of solar panels are configured to electrically connect the plurality of solar panels with each other and to the junction box.

According to one embodiment of the present invention, the flexible solar panel module further comprises a protective film disposed in a region between two openings of the plurality of openings to protect at least one of the positive ribbons and the negative ribbons.

According to one embodiment of the present invention, both the flexible polymer thin film and the protective film are thermalplastic polyolefin(TPO).

According to one embodiment of the present invention, in each of the plurality of openings each of the plurality of flexible back sheets is attached to one of the plurality of solar panels by a sealant.

According to one embodiment of the present invention, a size of each of the plurality of non-flexible cover panels is bigger than the size of each of the plurality of openings.

According to one embodiment of the present invention, a periphery region of each of the plurality of flexible back sheets is attached to the flexible polymer thin film by an adhesive and the adhesive is butyl rubber.

### BRIEF DESCRIPTION OF THE DRAWING

FIG. 1 shows a blown up view of a flexible solar panel module according to one embodiment of the present invention.
FIG. 2 shows a top view of a flexible solar panel module according to one embodiment of the present invention.
FIG. 3 shows a partial cross-sectional view of a flexible solar panel module according to one embodiment of the present invention.

### DESCRIPTION OF THE PREFERRED EMBODIMENTS

The following descriptions illustrate preferred embodiments of the present invention in detail. All the components, sub-portions, structures, materials and arrangements therein can be arbitrarily combined in any sequence despite their belonging to different embodiments and having different sequence originally. All these combinations are falling into the scope of the present invention.

There are a lot of embodiments and figures within this application. To avoid confusions, similar components are designated by the same or similar numbers. To simplify figures, repetitive components are only marked once.

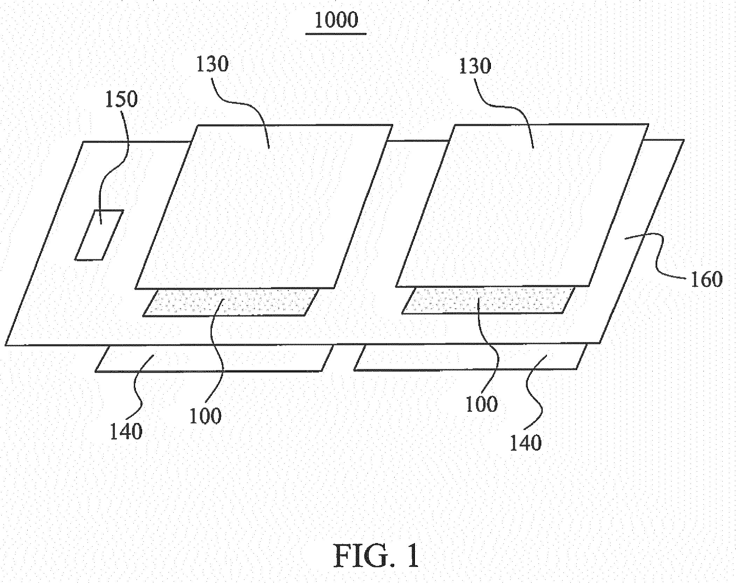

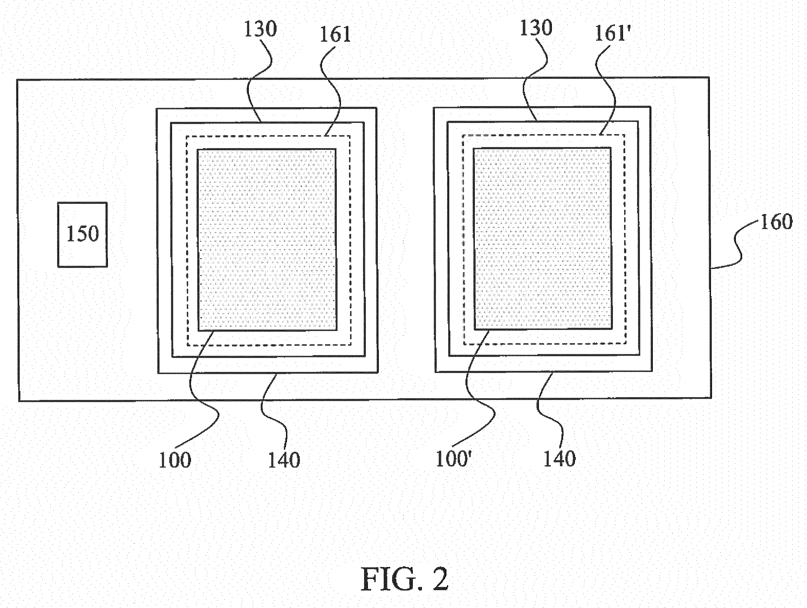

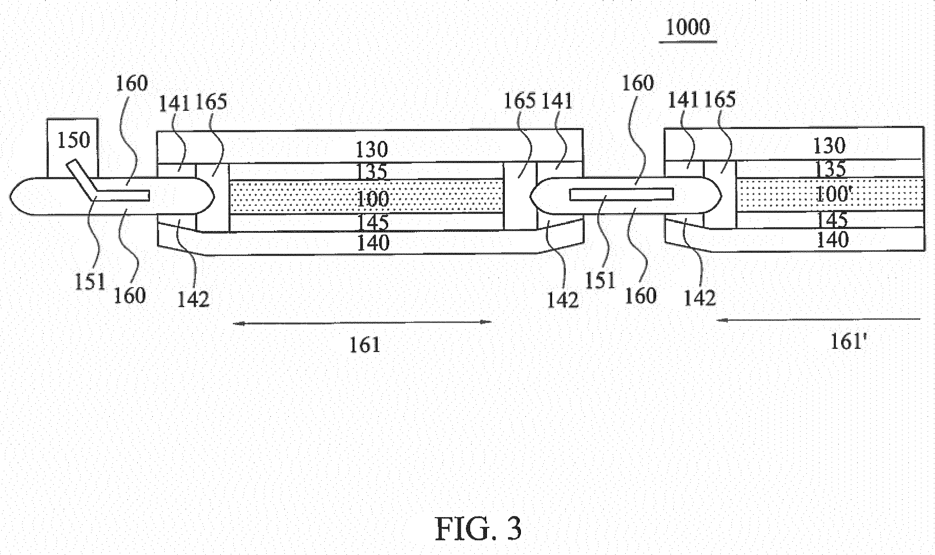

Now refer to FIGS. 1- 3. FIGS. 1-3 show blown up view, top view and partial cross-sectional view of a flexible solar panel module 1000 according to one embodiment of the present invention respectively. The flexible solar panel module 1000 comprises a plurality of solar panels for example solar panels 100 and 100', a plurality of cover panels 130, a plurality of flexible back sheets 140, a flexible polymer thin film 160 having openings 161 and 161', and a junction box 150 disposed on the front sides or the back sides of the plurality of solar panels (FIG. 3 shows the junction box 150 disposed on the front sides). Each solar panel 100 (100') has a front side such as a side subjected to sun light and a backside opposite to the front side. Each solar panel 100 (100') comprises a plurality of solar cell units (not shown) electrically connected in serial. Every solar panel 100 (100') preferably has the same size and the same shape such as a rectangle having a long side and a short side. The details of the solar panels 100 and 100' will be further discussed later. The plurality of cover panels 130 correspond to the plurality of solar panels 100 and 100' and cover front sides of the plurality of solar panels 100 and 100' respectively. A size of each cover panel 130 may be smaller than (as shown in FIG. 2) or equivalent to (as shown in FIG. 3) a size of each flexible back sheet 140. The size of each cover panel 130 is bigger than a size of each solar panel 100 or 100' to cover each solar panel 100 or 100' and is bigger than a size of each opening 161 or 161' in the flexible polymer thin film 160. The plurality of back sheets 140 correspond to the plurality of solar panels 100 and 100' and are disposed at back sides of the plurality of solar panels 100 and 100' respectively. The flexible polymer thin film 160 comprises a plurality of openings 161 and 161' therein corresponding to the plurality of solar panels 100 and 100'. A size of each opening 161 or 161' is smaller than a size of each cover panel, smaller than a size of each flexible back sheet 140, and bigger than a size of each solar panel 100 or 100'. The flexible polymer thin film 160 is disposed between the plurality of back sheets 140 and the plurality of cover panels 130. The plurality of openings 161 and 161' are so arranged in the flexible polymer thin film 160 that the plurality of solar panels 100 and 100' sandwiched between the plurality of back sheets 140 and the plurality of cover panels 130 are embedded in the plurality of openings 161 and 161' respectively. The present embodiment uses two solar panels as example, but a person of ordinary skills in the art should know it is possible for a flexible solar panel module to comprise more solar panels such as three, four, five, six solar panels, etc. The quantity of the cover panels, the flexible back sheets, and the openings in the flexible polymer thin film may change accordingly. Similarly, each solar panel may take different size and/or shape and the sizes and shapes of the cover panels, the flexible back sheets, and the openings in the flexible polymer thin film may change accordingly. Alternatively, the shapes of the cover panels, the flexible back sheets, and the openings in the flexible polymer thin film may be different from the shapes of the solar panels. For example, the solar panels may have rectangular shapes while the shapes of the openings may be rectangles with rounded corners.

Although not shown in the figures, each solar panel 100 or 100' comprises a stacked structure having from bottom to top a back glass, a patterned lower electrode layer, a patterned photoelectric conversion layer, an optional patterned buffer layer, and a patterned transparent upper electrode layer. The lower electrode layer and the transparent upper electrode layer are configured to conduct electrical current generated by the photoelectric conversion layer. The photoelectric conversion layer is configured to receive light penetrating the transparent upper electrode layer and the optional buffer layer and convert the light into electricity. The photoelectric conversion layer may be formed from a semiconductor material composed of copper (Cu), indium (In), gallium (Ga) and selenium (Se). Alternatively, the photoelectric conversion layer may be formed from a semiconductor compound material comprising Ib group element such as copper (Cu) or silver (Ag), IIIb group element such as aluminum (Al), gallium (Ga) or indium (In) and VIb group element such as sulfur (S), selenium (Se) or tellurium (Te). The transparent upper electrode layer for example is an indium tin oxide (ITO) layer and/or a zinc oxide (ZnO) layer. The optional buffer layer is configured to protect the photoelectric conversion layer during patterning of the photoelectric conversion layer and facilitate current conducting. The solar panels 100 and 100' are the same in view of their structures and their difference lies on their orientations. Therefore, this application only describes the solar panel 100 in detail and the details of the solar panel 100' are omitted. Each solar panel 100 (100') further comprises a positive ribbon and a negative ribbon (not shown in FIGS. 1 and 2; ribbon 151 shown in FIG. 3 represents the positive ribbon and/or the negative ribbon) at two long sides to electrically connect the plurality of solar panels 100 and 100' with each other and/or to electrically connect the plurality of solar panels 100 and 100' to an external terminal (for example through the junction box 150 as shown in FIG. 3). The ribbons for example can be made from copper foil, copper ribbon, foils of other metals or alloy or ribbons of other metals or alloys. Each solar panel 100 or 100' may comprise at least one solar cell unit or comprise many solar cell units electrically connected in serial.

The cover panels 130 for example are thinned glass panels, reinforced glass panels, or other rigid transparent polymer panels. The flexible back sheets 140 may be a high-tensile plastic sheets such as polyethylene (PE) sheet, polyamide (PA) sheets, polyethylene terephthalate (PET) sheets or a combination thereof. The back sheets may also be a combination of a material from above and a metallic foil attached thereto. The flexible polymer thin film 160 for example is a flexible water-resistant sealant such as thermalplastic polyolefin (TPO).

As shown in FIG. 3, the plurality of flexible back sheets 140, the plurality of solar panels 100 and 100' , and the plurality of cover panels 130 form a plurality of stacked structures, wherein in the openings 161 and 161' the plurality of flexible back sheets 140 are attached to the plurality of solar panels 100 and 100' respectively by a sealant 145 while the plurality of cover panels 130 are attached to the plurality of solar panels 100 and 100' respectively by a sealant 135. The sealant 135 and sealant 145 may use the same material or different materials for example a thermal encapsulant such as ethylene vinyl acetate (EVA), polyolefin (PO), polyvinyl butyral (PVB) or an UV curable encapsulant. In order to protect the plurality of solar panels 100 and 100' from moisture and/or mechanical force, in each opening of the openings 161 and 161' 161 and 161' a water-resistant sealant 165 such as butyl rubber is disposed surrounding a periphery region of a stacked structure composed of a flexible back sheet, a solar panel 100 or 100', and a cover panel 130. The water-resistant sealant 165 preferably fills in gaps between the plurality of solar panels 100 and 100' and the flexible polymer thin film 160 and physically contacts the plurality of solar panels 100 and 100', the flexible polymer thin film 160, the plurality of flexible back sheets 140, and the plurality of cover panels 130 so as to prevent moisture from contacting the plurality of solar panels 100/100'. There are gaps between the four sides of each of the plurality of solar panels 100 and 100' and flexible polymer thin film 160 and the water-resistant sealant 165 surrounds the four sides of each of the plurality of solar panels 100 and 100'. The water-resistant sealant 165 extends upward to contact each of the plurality of cover panels 130 and downward to contact each of the flexible back sheets 140. Since the size of each of the plurality of cover panels 130 and the size of each of the flexible back sheets 140 are both larger than the size of each opening of the openings 161 and 161', an adhesive 142 is disposed between the plurality of flexible back sheets 140 and the flexible polymer thin film 160 in regions outside the water-resistant sealant 165 and surrounding the plurality of flexible back sheets 140 respectively while an adhesive 141 is disposed between the plurality of cover panels 130 and the flexible polymer thin film 160 in regions outside the water-resistant sealant 165 and surrounding the plurality of cover panels 130 respectively. The adhesives 142 and 141 fill in gaps between the plurality of flexible back sheets 140 and the flexible polymer thin film 160 and gaps between the plurality of cover panels 130 and the flexible polymer thin film 160 respectively and keep the plurality of flexible back sheets 140, the flexible polymer thin film 160, and the plurality of cover panels 130 in position. The adhesives 142 and 141 may be a water-resistant sealant such as butyl rubber.

Still refer to FIG. 3. An appropriate distance should be kept between each solar panel 100 and its adjacent solar panel 100' to avoid interference between adjacent solar panels 100 and 100' and to reserve space for electrical routing. This means an appropriate distance should be kept between each opening 161 and its adjacent opening 161'. Because the positive ribbon and/or the negative ribbon of a solar panel such as the solar panel 100 may cross adjacent openings such as the openings 161 and 161' to electrically connect the solar panel to another solar panel such as the solar panel 100', a protective film may be additionally disposed in a region between adjacent openings to protect the positive ribbon and/or the negative ribbon from moisture or external influences and to reinforce mechanical strength of the region between adjacent openings. In this embodiment, the protective film is a flexible water-resistant sealant such as thermalplastic polyolefin (TPO), thus in the regions between adjacent openings the positive ribbon and/or the negative ribbon 151 are sandwiched by two flexible polymer thin films 160. Since the junction box 160 is disposed on the flexible polymer thin film 160 in a region besides a solar panel 100, another protective film (shown as another flexible polymer thin film 160 in FIG. 3) may be additionally disposed in said region sandwiching the positive ribbon and/or negative ribbon 151 electrically connecting the junction box 150 and the solar panel 10 to reinforce mechanical strength of said region, to support the junction box 150 reliably, and to protect the positive ribbon and/or negative ribbon 151. Although the present invention specifically instructs adding protective films for ribbons and for junction box, protective films may be added to any regions requiring more mechanical strength or extra protection. The material and quantity of the protective film are not limited to the examples mentioned here and one or more of material layers compatible with the flexible polymer thin film 160 may be used. Alternatively, one may modify or dope the flexible polymer thin film 160 locally to enhance its mechanical strength, water resistance, and/or any other physical or chemical properties.

The flexible solar panel module of the present invention is capable of generating high power, has better flexibility to fit various topographies and has advantage of high reliability due to high water-resistance. Furthermore, it is easy to fabricate and install the flexible solar panel module of the present invention, so manufacturing cost is reduced and utility is increased.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A flexible solar panel module (1000) comprising:
a plurality of solar panels (100, 100');
a plurality of cover panels (130) corresponding to the plurality of solar panels (100, 100') and covering front sides of the plurality of solar panels (100, 100') respectively;
a plurality of flexible back sheets (140) corresponding to the plurality of solar panels (100, 100') and disposed at back sides of the plurality of solar panels (100, 100') respectively; and
a flexible polymer thin film (160) comprising a plurality of openings (161, 161') therein corresponding to the plurality of solar panels (100, 100') and a size of each of the plurality of openings (161, 161') is smaller than a size of each of the plurality of cover panels (130) and bigger than a size of each of the plurality of solar panels (100, 100'),
wherein the flexible polymer thin film (160) is disposed between the plurality of flexible back sheets (140) and the plurality of cover panels (130),
wherein the plurality of openings (161, 161') are so arranged in the flexible polymer thin film (160) that the plurality of solar panels (100, 100') sandwiched between the plurality of flexible back sheets (140) and the plurality of cover panels (130) are embedded in the plurality of openings (161, 161') respectively.

2. The flexible solar panel module of claim 1, further comprising a junction box (150) disposed on the front sides of the plurality of solar panels (100, 100').

3. The flexible solar panel module of claim 2, wherein each of the plurality of solar panels (100, 100') comprises a photoelectric conversion layer, a positive ribbon and a negative ribbon (151).

4. The flexible solar panel module of claim 3, wherein the positive ribbons and the negative ribbons (151) of the plurality of solar panels (100, 100') are configured to electrically connect the plurality of solar panels (100, 100') with each other and to the junction box (150).

5. The flexible solar panel module of claim 4, further comprising a protective film (160) disposed in a region between two openings of the plurality of openings (161, 161') to protect at least one of the positive ribbons and the negative ribbons (151).

6. The flexible solar panel module of claim 5, wherein both the flexible polymer thin film (160) and the protective film (160) are thermalplastic polyolefin (TPO).

7. The flexible solar panel module of claim 1, further comprising a water-resistant sealant forming physical contacts between the plurality of cover panels (130) and the plurality of solar panels (100, 100'), between the flexible polymer thin film (160) and the plurality of solar panels (100, 100'), and between the plurality of flexible back sheets (140) and the plurality of solar panels (100, 100').

8. The flexible solar panel module of claim 1, wherein a size of each of the plurality of flexible back sheets (140) is bigger than the size of each of the plurality of openings (161, 161').

9. The flexible solar panel module of claim 8, wherein a periphery region of each of the plurality of flexible back sheets (140) is attached to the flexible polymer thin film (160) by an adhesive (142).

10. The flexible solar panel module of claim 9, wherein the adhesive is a water-resistant sealant.
